(19) Europäisches Patentamt
European Patent Office
Office européen des brevets

(11) Publication number: **0 172 704 B1**

(12) # EUROPEAN PATENT SPECIFICATION

(45) Date of publication of patent specification: **08.05.91**

(51) Int. Cl.$^5$: **H03G 3/20**, H04B 1/40

(21) Application number: **85305615.8**

(22) Date of filing: **07.08.85**

(54) **Battery-powered radio communication apparatus capable of prolonging the communicable state thereof.**

(30) Priority: **14.08.84 JP 168852/84**

(43) Date of publication of application:
**26.02.86 Bulletin 86/09**

(45) Publication of the grant of the patent:
**08.05.91 Bulletin 91/19**

(84) Designated Contracting States:
**DE FR GB SE**

(56) References cited:
**EP-A- 0 135 154**
**WO-A-85/00082**
**US-A- 4 370 622**
**US-A- 4 392 245**
**US-A- 4 458 209**

(73) Proprietor: **NEC CORPORATION**
**7-1, Shiba 5-chome Minato-ku**
**Tokyo 108-01(JP)**

(72) Inventor: **Tamura, Yoshiharu**
**c/o NEC Corporation 33-1 Shiba 5-chome**
**Minato-ku Tokyo(JP)**
Inventor: **Kimura, Katsuji**
**c/o NEC Corporation 33-1 Shiba 5-chome**
**Minato-ku Tokyo(JP)**

(74) Representative: **Orchard, Oliver John**
**JOHN ORCHARD & CO. Staple Inn Buildings**
**North High Holborn**
**London WC1V 7PZ(GB)**

**EP 0 172 704 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

This invention relates to a battery-powered radio communication apparatus and, more particularly, to a battery-powered radio communication apparatus with an automatic gain control (AGC) circuit at the stage of power amplifier.

The portable battery-powered radio communication apparatus normally operates at a battery voltage which is higher than a preset voltage. When the battery voltage drops below the preset voltage, the radio communication apparatus is forced to be out of its normal operation, which, in turn, results in interruption of communication. The AGC circuit, if provided at the stage of power amplifier, works to keep the output power of the apparatus constant and, therefore, the drop in battery voltage causes increase in current consumption. Accordingly, upon beginning to drop, the battery voltage falls rapidly, as the case may be, below the preset voltage, with consequent interruption of communication.

### SUMMARY OF THE INVENTION

Accordingly, it is an object of the invention to provide a battery-powered radio communication apparatus permitting communication to be maintained for some time even if the battery voltage has fallen.

In WO 85/00082, there is described a mobile transmitter arrangement having a power output amplifier and a voltage supply which supplies either a low or a high voltage to the amplifier according to a demand signal. This arrangement suffers from the disadvantages referred to above.

The present invention is defined in the claims.

### BRIEF DESCRIPTION OF THE DRAWINGS

Other objects, features and advantages of the invention will become more apparent from the description given hereinafter with reference to the accompanying drawings, in which

Fig. 1 is a block diagram of a conventional radio communication apparatus;

Fig. 2 is a graph showing the time course of the terminal voltage of a battery connected to the apparatus of Fig. 1;

Fig. 3 is a graph showing the time course of transmission power of the apparatus of Fig. 1;

Fig. 4 is a block diagram of an embodiment of radio communication apparatus according to the invention;

Fig. 5 is a graph showing the time course of the terminal voltage of a battery connected to the apparatus of Fig. 4;

Fig. 6 is a graph showing the time course of transmission power of the apparatus of Fig. 4;

Fig. 7 is a graph illustrating discharge characteristics of the battery, taking load current as a parameter;

Fig. 8 is a graph illustrating the relationship, taking discharge capacity as a parameter, between the terminal voltage of battery and load current; and

Figs. 9 and 10 are block diagrams showing the detailed circuit structures of the power amplifier circuit and the supply voltage detector shown in Fig. 4.

### DETAILED DESCRIPTION OF THE INVENTION

In Fig. 1, the conventional radio communication apparatus includes a transmitter section 51, a receiver section 52, a frequency synthesizer 53, a control unit 54 and a power amplifier circuit 2. A battery 1 supplies power to the above-mentioned sections or circuits. It is to be noted that a terminal 59a is connected to terminals 59b and 59c. A speech signal is inputted to the control unit 54 through a microphone 55 and in turn applied to the transmitter section 51. The transmitter section modulates a carrier wave with the speech signal and frequency converts the modulated carrier wave into a radio frequency signal. The power amplifier circuit 2 amplifies the radio frequency signal and supplies it to an antenna 58 via a duplexer 57 to radiate the amplified signal. The apparatus may comprise a keyboard with which data can be inputted to the unit 54. The data is radiated like the speech signal.

A transmitted signal which may contain a speech signal or data, is picked up by the antenna 58 and supplied to the receiver section 52 through the duplexer 57. In the receiver section 52, the received signal is subject to the frequency conversion, demodulation or the like to become a baseband signal. When the received signal contains a speech signal, the speech signal is supplied to a speaker 56 by way of the control unit 54. When it contains data, the data is subject to necessary treatment within the control unit 54. Under the control of the control unit 54, the frequency synthesizer 53 supplies local oscillation signals to the transmitter and receiver sections 51 and 52 for the frequency conversion.

The power amplifier circuit 2 comprises an AGC circuit 5 to keep the output power of the apparatus constant. In the AGC circuit 5, a power detector 6 detects the output power of a power amplifier 4 and a gain control circuit 7 controls the gain of the amplifier 4 in response to the detected output power. The power detector 6 and the gain control circuit 7 constitute a negative feedback loop.

In general, the radio communication apparatus can operate normally at not lower than a certain battery voltage, which is minimum voltage $V_1$ (see Fig. 2). At voltages less than $V_1$, desired characteristic and function can not be maintained properly, and undesired operation occurs. At the point of time $t_1$ corresponding to $V_1$, therefore, transmission is stopped, and then replacement with a new battery or charging the battery is made. This brings the apparatus into suspension or out of use until the return to voltage $V_0$.

As shown in Fig. 2, a fully-charged battery continues to apply a constant terminal voltage $V_0$ during a certain period and thereafter the terminal voltage falls gradually. The AGC circuit 5 operates to keep the output power constant independently of change in battery voltage. Therefore with the AGC circuit 5, ideally, a certain output power $P_0$ is maintained until time $t_1$ when the battery voltage becomes $V_1$, as indicated by the solid line in Fig. 3. In non-ideal case where the battery voltage falls and the maximum output of power amplifier 4 is below $P_0$, owing to the effect of AGC circuit 5 towards the maintenance of the maximum output, the output follows the time course as the dotted line in Fig. 3, with a slight drop in power. Thus, the current consumption reduces gradually, and the battery voltage becomes $V_1$ at time $t_2$. In practice, the prolonged time $t_2 - t_1$ is only short and departure out of normal operation of such radio communication apparatus occurs suddenly. In order to avoid defect like this, usually is designated $V_A$ ($V_1 < V_A < V_0$) battery voltage at time $t_A$, at which some alarm is given.

The prior art radio communication apparatus, however, is disadvantageous in that time length from time $t_A$ when the alarm is generated to the time when it gets mulfunctioned: $t_1 - t_A$ or $t_2 - t_A$ is too short to satisfactorily avoid sudden interruption of communication.

A radio communication apparatus embodying the present invention is shown in Fig. 4. In Fig. 4, sections or circuits which are demoted by the same reference numerals as in Fig. 1 have the same functions as those in Fig. 1. A reference numeral 9 indicates a supply voltage detector which operates only when the battery voltage V is lower than a standard voltage; and 10, an input terminal to which the standard voltage is applied from a control unit 154. The control unit 154 may include a Zener diode to produce the standard voltage from the battery voltage.

The supply voltage detector 9 detects whether the battery voltage V becomes lower than the standard voltage or not by comparing them. When the voltage V became lower than the standard voltage, the supply voltage detector 9 supplies a control signal to an AGC circuit 500. In response to the control signal, the AGC circuit 500 controls the gain of the power amplifier 4 so that the transmission power decreases to a certain level. This results in slowing drop of voltage of the battery 1 and thereby prolonging the operative condition of the apparatus. The supply voltage detector 9, the power amplifier circuit 200 and power supply line constitute a negative feedback loop.

Supposing that $V_2$ which is $V_1 < V_2 < V_0$ is taken as the standard voltage and that the negative feedback loop has a high loop gain. The power supply voltage V will be maintained at the standard voltage $V_2$ for some time after the voltage V has become the voltage $V_2$ at time $t_3$ (see Fig. 5). At $t_4$, the voltage V begins to again fall, because the whole current of the radio communication apparatus does not become below a certain level even if the transmission power continues to decrease. The time-transmission power characteristic is shown in Fig. 6. In comparison among Figs. 2, 3, 5 and 6, it appears to be $t_1 < t_2 < t_4$.

As shown in Fig. 6, when the transmission power P gradually drops, it passes a transmission output $P_5$ below which communication is highly deteriorated or becomes impossible due to a long distance to a partner or to obstacles. Now letting the transmission power at time $t_4$ when the battery voltage V is $V_1$ be $P_4$, and taking $P_4 < P_5$, then incommunicability resulting from the drop in transmission power is earlier than that due to drop in the battery voltage. It is clear that this tendency is greater in communication in the vicinity of the boundary of the communicable area. Thus, it follows that the greater the transmission power $P_0$ is, compared with the transmission power $P_5$, the more the communicable state of the apparatus is prolonged. Of course, in an apparatus of the type in which the transmission is interrupted in response to the battery voltage equal to $V_1$, the communication time can be lengthened at least by $t_5 - t_1$, so far as transmission power $P_0$ is greater than transmission power $P_5$ ($P_5 < P_0$).

The reasons for that the battery voltage V is maintained at the standard voltage $V_2$ will now be described with reference to Figs. 7 and 8. The battery voltage V at a certain discharge capacity C becomes high with decreasing a load current. If the discharge capacity is changed from $C_1$ to $C_3$ at time $t_3$ (see Fig. 5), the current I decreases from $I_1$ to $I_3$ as indicated by the arrow in Fig. 7 to maintain the voltage $V_2$. Likewise, when the voltage V is plotted with respect to the load current I, using the discharge capacity C as a parameter, the graph as shown in Fig. 8 is obtained. In addition, current $I_4$ is the maximum output-reduction value of the power amplifier circuit 200 or the minimum current consumption value of the apparatus.

In Fig. 9, the power amplifier circuit 200 and the supply voltage detector 9 are shown in more detail. A reference numeral 21 denotes a voltage input terminal to which a constant voltage is applied from the control unit 154 (Fig. 4) to control the output of the power amplifier circuit 2. A potentiometer 21 adjusts the constant voltage. A voltage variable circuit 23 is adapted to change the voltage applied from the battery 1 to the power amplifier 4.

A differential amplifier 19 amplifies a difference voltage between the battery voltage V and the standard voltage $V_2$ which are adjusted with voltage-divider resistors 11 and 12, and 13 and 14 to appropriate voltages, respectively. When the adjusted battery voltage is higher than the adjusted standard voltage, and the amplification factor of the differential amplifier 19 defined by the ratio of resistors 15, 16 is sufficiently great, the voltage of the output terminal 27 becomes substantially equal to the adjusted battery voltage applied to the differential amplifier 19. Furthermore, if the voltage $V_+$ applied to the non-inverting input terminal 28 of a differential amplifier 26 is lower than the voltage of the output terminal 27, the diode 20 is in a non-conductive condition. As a result, the voltage $V_+$ becomes substantially equal to voltage $V_s$ defined by the constant voltage applied to the voltage input terminal 21 and adjusted by the potentiometer 22. Then, as soon as the adjusted battery voltage becomes lower than the adjusted standard voltage, the voltage of the output terminal 27 begins to rapidly fall, and the diode 20 is rendered conductive, the voltage $V_+$ varies with the voltage of the output terminal 27. Moreover, by letting the polarities of the differential amplifiers 19 and 26 be as shown in Fig. 9, the aforesaid negative feedback loop can be constituted. Accordingly, the amplifier 26 can control the voltage supplied to the power amplifier 4 in accordance with the variations of the battery voltage V.

Referring to Fig. 10, other circuit structures of the power amplifier circuit 200 and the supply voltage detector 9 are shown. A voltage variable circuit 36 changes the input voltage of the power amplifier 4 in response to the output of a differential amplifier 35. Terminals 37 and 41 are supplied with constant voltages like the terminal in Fig. 9. The radio communication apparatus shown in Fig. 10 operates the same as that shown in Fig. 9 except that the voltage variable circuit 36 is used and that a feedback loop is set by adjusting a voltage $V_B$ superposed on a power detector 600. If the battery voltage V falls below the standard voltage $V_2$, the voltage $V_B$ rises in accordance with the output of a differential amplifier 29, resulting in the consequent drop of the transmission power.

As in detailed described above, the battery-powered radio communication apparatus according to the invention permits the prolonged critical period of battery by, after detecting the critical terminal voltage of the battery, causing the transmission output to gradually fall. Thus when some alarm is given as soon as the voltage has reached critical voltage, interval from the time of generation of the alarm to the time of occurrence of incommunicability is prolonged with effect of enabling sufficiently to prevent communication or call from infavorably being interrupted.

## Claims

1. A radio communication apparatus comprising a power amplifier (4) for amplifying an input signal and a battery (1) for supplying power to said power amplifier (4), characterised by comprising first means (9) for comparing the output voltage of said battery (1) with a standard voltage to provide a control signal when the output voltage falls below the standard voltage; and an automatic gain control circuit (500) for detecting the output power of the power amplifier (4) to provide a detected signal,for controlling the output of the power amplifier (4) in response to the detected signal, and for reducing the output power in response to the control signal.

2. A radio communication apparatus as claimed in claim 1 wherein said first means (9) comprises a first differential amplifier (19) for comparing the output voltage of said battery (1) with said standard voltage, and wherein said gain control circuit (700) comprises a second differential amplifier (26) for comparing the output of said first differential amplifier (19) with said detected signal and second means (23) for varying the supply voltage from said battery (1) to said power amplifier (4) in response to the output of said second differential amplifier (26).

3. A radio communication apparatus as claimed in claim 1 wherein said automatic gain control circuit (500) comprises a power detector (600) including directional couplers (41 and 42) for branching the output of said power amplifier (4); and a diode (40) for detecting the branched signal to provide said detected signal.

4. A radio communication apparatus as claimed in claim 1 wherein said automatic gain control circuit (500) comprises a power detector (600) for detecting the output voltage of said power amplifier (4) and voltage-superposing the detected voltage onto the voltage of said control signal to provide a voltage-superposed signal, and a gain control circuit (700) for changing the voltage of said input signal in response to said voltage-superposed signal.

**5.** A radio communication apparatus as claimed in claim 4 wherein said first means (9) comprises a first differential amplifier (29) for comparing the output voltage of said battery (1) with said standard voltage, and wherein said gain control circuit (700) comprises a second differential amplifier (35) for comparing a predetermined voltage with the voltage of said voltage-superposed signal.

**6.** A radio communication apparatus as claimed in claim 4 wherein said power detector (600) comprises directional couplers (41 and 42) for branching the output of said power amplifier (4), and a diode (40) for detecting the branched signal to provide said detected voltage.

**7.** A method for prolonging the communicable state of a battery-powered radio communication apparatus including means for automatically controlling a power amplifier (4) therein, comprising the steps of:

(a) detecting the output power of said power amplifier (4), to provide a detected signal;

(b) detecting the voltage of a battery (1) which supplies power to said power amplifier (4), to provide a control signal when the voltage of the battery falls below a standard voltage;

(c) controlling the output power of the power amplifier (4) responsive to said detected signal; and reducing the output power responsive to the control signal.

**8.** A method as claimed in claim 7 wherein said step (b) comprises the step of (d) comparing the voltage of said battery (1) with said standard voltage to provide said control signal.

**9.** A method as claimed in claim 7 wherein said step (c) comprises the steps of: (e) voltage comparing said detected signal with said control signal; and (f) varying, responsive to the result obtained by the step (e), the supply voltage of said battery (1) to said power amplifier (4).

**10.** A method as claimed in claim 8 further comprising the steps of: (e) superposing said control signal onto said detected signal to provide a superposed signal; and (f) varying the input signal voltage to said power amplifier (4) in response to said voltage-superposed signal.

**11.** A method as claimed in claim 7 wherein said step (a) comprises the steps of: (d) branching the output of said power amplifier (4) and (e) detecting the branched signal to provide said detected signal.

## Revendications

**1.** Appareil de radiocommunication comprenant un amplificateur de puissance (4) pour amplifier un signal d'entrée et une batterie (1) peur fournir de l'énergie à l'amplificateur de puissance (4), caractérisé en ce qu'il comprend un premier moyen (9) servant à comparer la tension en sortie de la batterie (1) à une tension normalisée pour délivrer un signal de commande lorsque la tension en sortie chute au-dessous de la tension normalisée et un circuit de commande automatique de gain (500) pour détecter la puissance de sortie d'amplificateur de puissance (4) pour délivrer un signal détecté afin de commander la sortie de l'amplificateur de puissance (4) en réponse au signal détecté et de réduire la puissance de sortie en réponse au signal de commande.

**2.** Appareil de radiocommunication selon la revendication 1, dans lequel le premier moyen (9) comprend un premier amplificateur différentiel (19) pour comparer la tension en sortie de la batterie (1) à la tension normalisée, et dans lequel le circuit de commande de gain (700) comprend un second amplificateur différentiel (26) cour comparer la sortie du premier amplificateur différentiel (19) au signal détecté et un second moyen (23) pour faire varier la tension d'alimentation provenant de la batterie (1) vers l'amplificateur de puissance (4) en réponse à la sortie du second amplificateur différentiel (26).

**3.** Appareil de radiocommunication selon la revendication 1, dans lequel le circuit de commande automatique de gain (500) comprend un détecteur de puissance (600) comprenant des coupleurs directionnels (41 et 42) afin de dériver la sortie de l'amplificateur de puissance (4) et une diode (40) pour détecteur le signal dérivé afin de délivrer le signal détecté.

**4.** Appareil de radiocommunication selon la revendication 1, dans lequel le circuit de commande automatique de gain (500) comprend un détecteur de puissance (600) pour détecter la tension en sortie de l'amplificateur de puissance (4) et pour superposer la tension de la tension détectée sur la tension du signal de commande afin de délivrer un signal à tension superposée et un circuit de commande de gain (700) pour modifier la tension du signal d'entrée en réponse au signal à tension superposée.

**5.** Appareil de radiocommunication selon la revendication 4, dans lequel le premier moyen (9) comprend un premier amplificateur différentiel (29) pour comparer la tension en sortie de la batterie (1) à la tension normalisée et dans lequel le circuit de commande de gain (700) comprend un second amplificateur différentiel (35) pour comparer une tension prédéterminée à la tension du signal à tension superposée.

**6.** Appareil de radiocommunication selon la revendication 4, dans lequel le détecteur de puissance (600) comprend des coupleurs directionnels (41 et 42) pour dériver la sortie de l'amplificateur de puissance (4) et une diode (40) peur détecter le signal dérivé afin de délivrer la tension détectée.

**7.** Procédé peur prolonger l'état de communication d'un appareil de radiocommunication alimenté par batterie comprenant un moyen pour commander automatiquement un amplificateur de puissance (4) disposé dans celui-ci, comprenant les opérations consistant à :

(a) détecter la puissance de sortie de l'amplificateur de puissance (4) afin de délivrer un signal détecté ;

(b) détecter la tension d'une batterie (1) qui alimente en puissance l'amplificateur de puissance (4) afin de délivrer un signal de commande lorsque la tension de la batterie chute en-dessous d'une tension normalisée ;

(c) commander la puissance de sortie de l'amplificateur de puissance (4) sensible au signal détectée et diminuer la puissance de sortie sensible au signal de commande.

**8.** Procédé selon la revendication 7, dans lequel l'opération (b) comprend l'opération (d) consistant à comparer la tension de la batterie (1) à la tension normalisée peur délivrer le signal de commande.

**9.** Procédé selon la revendication 7, dans lequel l'opération (c) comprend les opérations consistant à : (e) comparer la tension du signal détecté au signal de commande et (f) faire varier, en fonction du résultat obtenu par l'opération (e), la tension d'alimentation de la batterie (1) à l'amplificateur de puissance (4).

**10.** Procédé selon la revendication 8, comprenant en outre les opérations consistant à : (e) superposer le signal de commande sur le signal détecté afin de délivrer un signal superposé et (f) faire varier la tension du signal d'entrée vers l'amplificateur de puissance (4) en réponse au signal à tension superposée.

**11.** Procédé selon la revendication 7, dans lequel l'opération (a) comprend les opérations consistant à : (d) dériver la sortie de l'amplificateur de puissance (4) et (e) détecter le signal dérivé afin de délivrer le signal détecté.

## Ansprüche

**1.** Funkgerät mit einem Leistungsverstärker (4) zum Verstärken eines Eingangsignals und mit einer Batterie (1) zur Stromversorgung des Leistungsverstärkers (4), **gekennzeichnet durch** eine erste Einrichtung (9) zum Vergleichen der Ausgangsspannung der Batterie (1) mit einer Referenzspannung, um ein Steuersignal zur Verfügung zu stellen, wenn die Ausgangsspannung unter die Referenzspannung fällt; und einem automatischen Verstärkungsfaktorsteuerschaltkreis (500) zum Feststellen der Ausgangsleistung des Leistungsverstärker (4), um ein Ergebnissignal zum Steuern des Ausgangs des Leistungsverstärkers (4) als Reaktion auf das Ergebnissignal zur Verfügung zu stellen und die Ausgangsleistung als Reaktion auf das Steuersignal zu reduzieren.

**2.** Funkgerät nach Anspruch 1, wobei die erste Einrichtung (9) einen ersten Differentialverstärker (19) zum Vergleichen der Ausgangsspannung der Batterie (1) mit der Referenzspannung aufweist, und wobei ein Verstärkungsfaktorsteuerschaltkreis (700) einen zweiten Differentialverstärker (26) aufweist, um den Ausgang des ersten Differentialverstärkers (19) mit dem Ergebnissignal zu vergleichen, und eine zweite Einrichtung (23) aufweist, um die von der Batterie (1) dem Leistungsverstärker (4) zugeführte Spannung als Reaktion auf den Ausgang des zweiten Differentialverstärkers (26) zu verändern.

**3.** Funkgerät nach Anspruch 1, wobei der automatische Verstärkungsfaktorsteuerschaltkreis (500) einen Leistungsdetektor (600) mit Richtungskopplern (41 und 42) zum Verzweigen des Ausgangs des Leistungsverstärkers (4) und eine Diode (40) aufweist, um das verzweigte Signal festzustellenund das Ergebnissignal zur Verfügung zu stellen.

4. Funkgerät nach Anspruch 1, wobei der automatische Verstärkungsfaktorsteuerschaltkreis (500) einen Leistungsdetektor (600) zum Feststellen der Ausgangsspannung des Leistungsverstärkers (4) und zur Spannungsüberlagerung der festgestellten Spannung auf die Spannung des Steuersignals, um ein spannungsüberlagertes Signal zur Verfügung zu stellen, und einen Verstärkungsfaktorsteuerschaltkreis (700) aufweist, um die Spannung des Eingangssignals als Reaktion auf das spannungsüberlagerte Signal zu verändern.

5. Funkgerät nach Anspruch 4, wobei die erste Einrichtung (9) einen ersten Differentialverstärker (29) zum Vergleichen der Ausgangsspannung der Batterie (1) mit der Referenzspannung und der Verstärkungsfaktorsteuerschaltkreis (700) einen zweiten Differentialverstärker (35) zum Vergleichen einer vorbestimmten Spannung mit der Spannung des spannungsüberlagerten Signals aufweist.

6. Funkgerät nach Anspruch 4, wobei der Leistungsdetektor (600) Richtungskoppler (41 und 42) zum Verzweigen des Ausgangs des Leistungsverstärkers (4) und eine Diode (40) aufweist, um das verzweigte Signal festzustellen und die festgestellte Spannung zur Verfügung zu stellen.

7. Verfahren zum Verlängern des Verbindungszustandes eines batteriegespeisten Funkgeräts, das eine Einrichtung zum automatischen Steuern eines Leistungsverstärkers (4) enthält, mit den Schritten:
   (a) Feststellen der Ausgangsleistung des Leistungsverstärkers (4), um ein Ergebnissignal zur Verfügung zu stellen;
   (b) Feststellen der Spannung einer Batterie (1), welche die Stromversorgung des Leistungsverstärker (4) bildet,um ein Steuersignal zur Verfügung zu stellen, wenn die Spannung der Batterie unter eine Referenzspannung absinkt;
   (c) Steuern der Ausgangsleistung des Leistungsverstärkers (4) als Reaktion auf das Ergebnissignal, und Reduzieren der Ausgangsleistung als Reaktion auf das Steuersignal.

8. Verfahren nach Anspruch 7, wobei der Schritt (b) den Schritt aufweist:
   (d) Vergleichen der Spannung der Batterie (1) mit der Referenzspannung, um das Steuersignal zur Verfügung zu stellen.

9. Verfahren nach Anspruch 7, wobei der Schritt (c) die Schritte aufweist:
   (e) Vergleichen der Spannung des Ergebnissignals mit der des Steuersignals; und
   (f) Verändern der Versorgungspannung von der Batterie (1) zu dem Leistungsverstärker (4) als Reaktion auf das Ergebnis, das durch den Schritt (e) erhalten wurde.

10. Verfahren nach Anspruch 8 ferner mit den Schritten:
   (e) Überlagern des Steuersignals auf das Ergebnissignal, um ein überlagertes Signal zur Verfügung zu stellen; und
   (f) Verändern der Eingangssignalspannung an dem Leistungsverstärker (4) als Reaktion auf das spannungsüberlagerte Signal.

11. Verfahren nach Anspruch 7, wobei der Schritt (a) die folgenden Schritte aufweist:
   (d) Verzweigen des Ausgangs des Leistungsverstärkers (4) und
   (e) Feststellen des verzweigten Signals, um das Ergebnissignal zur Verfügung zu stellen.

Fig. 1. PRIOR ART

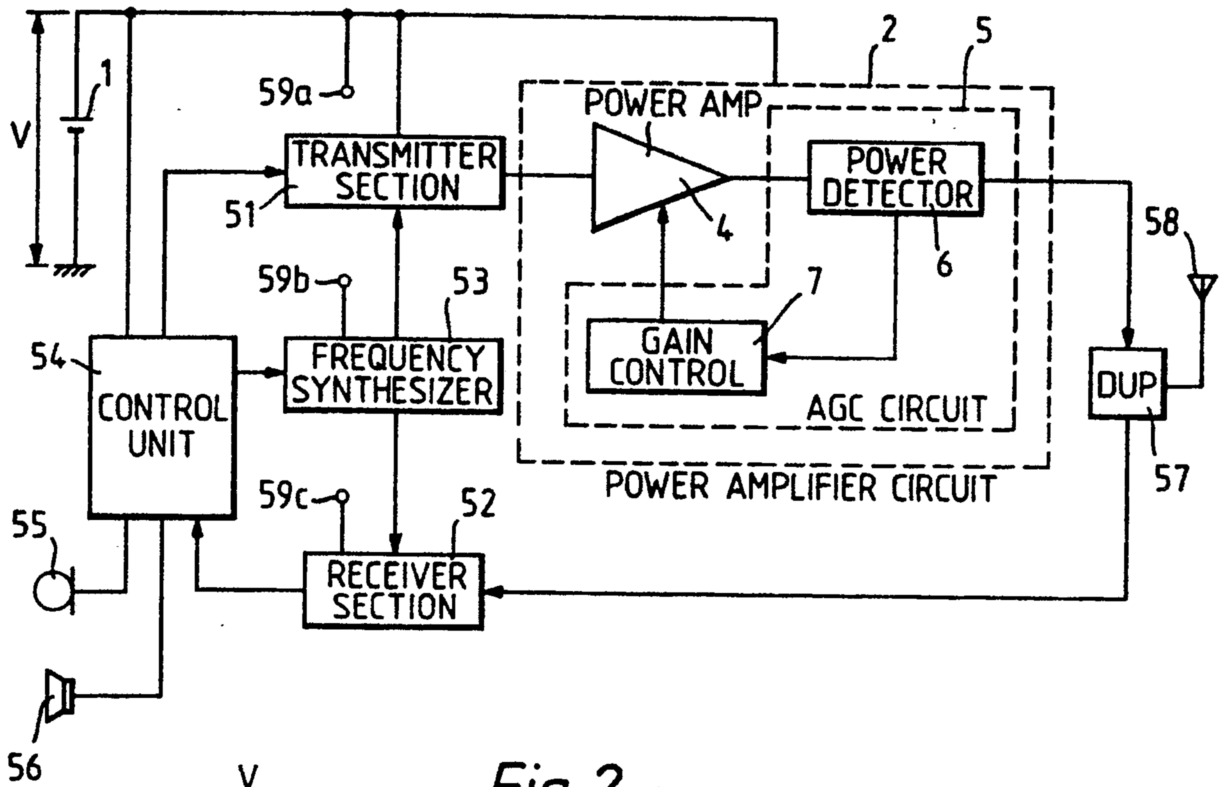


Fig. 2. PRIOR ART

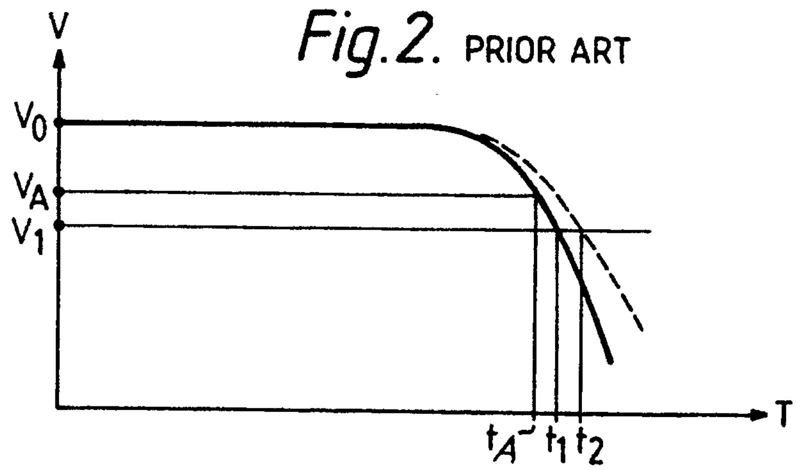


Fig. 3. PRIOR ART

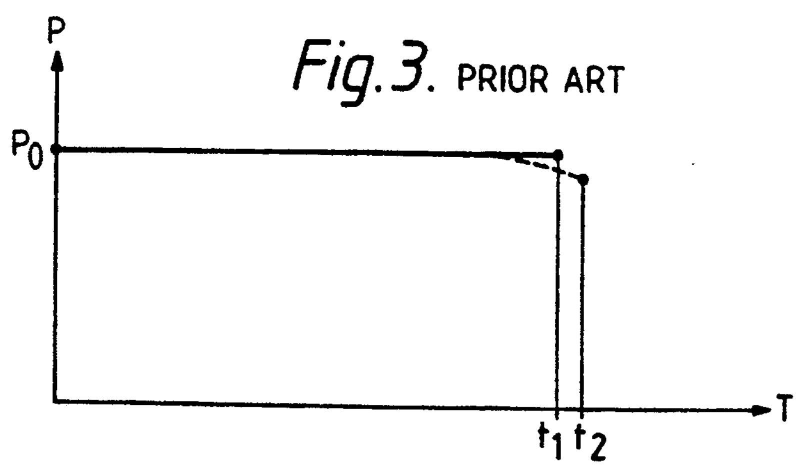

Fig.4.

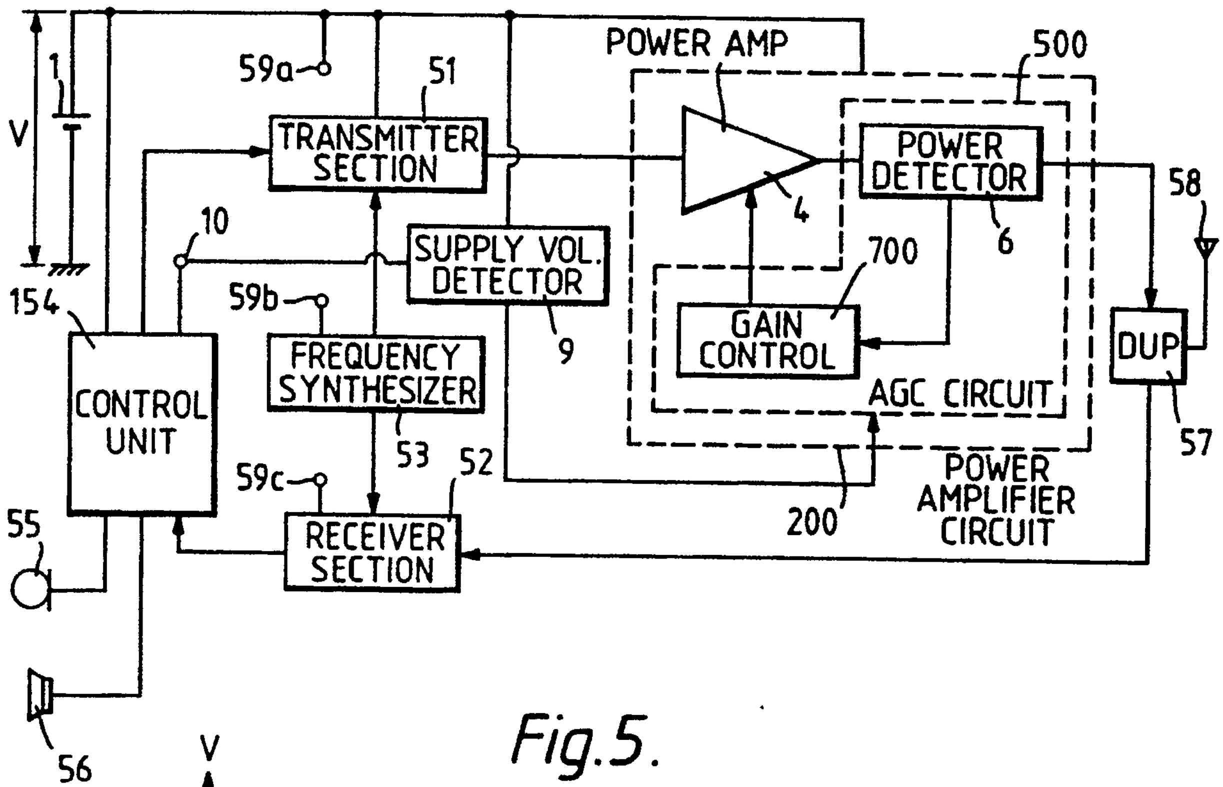


Fig.5.

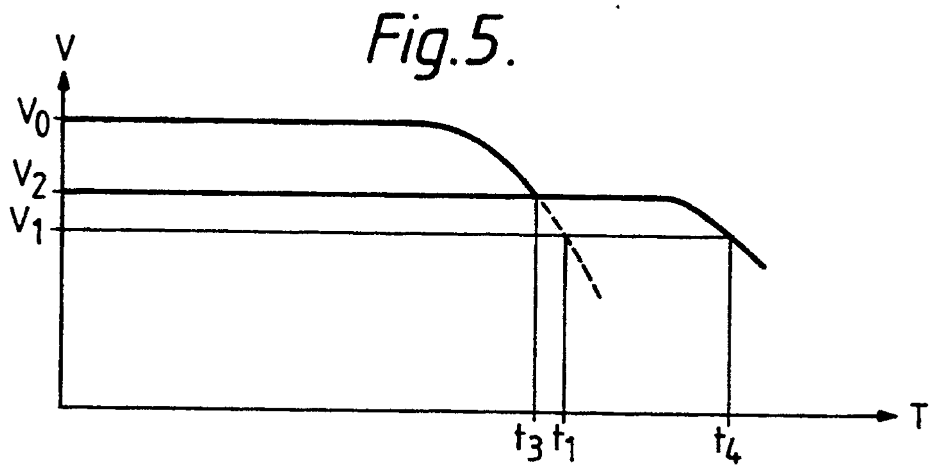


Fig.6.

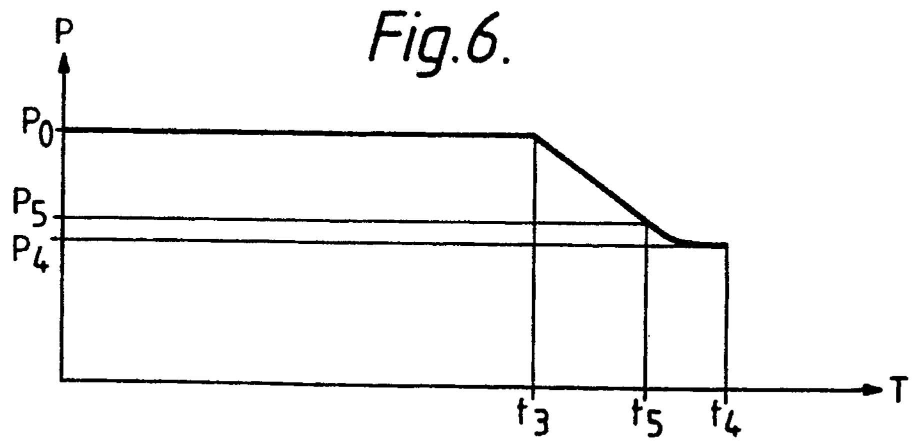

Fig.7.

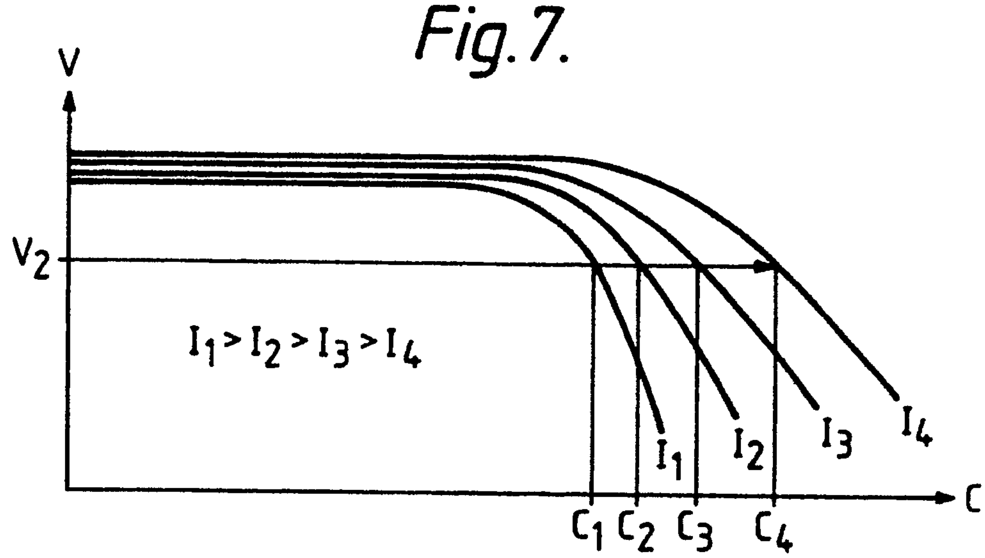


Fig.8.

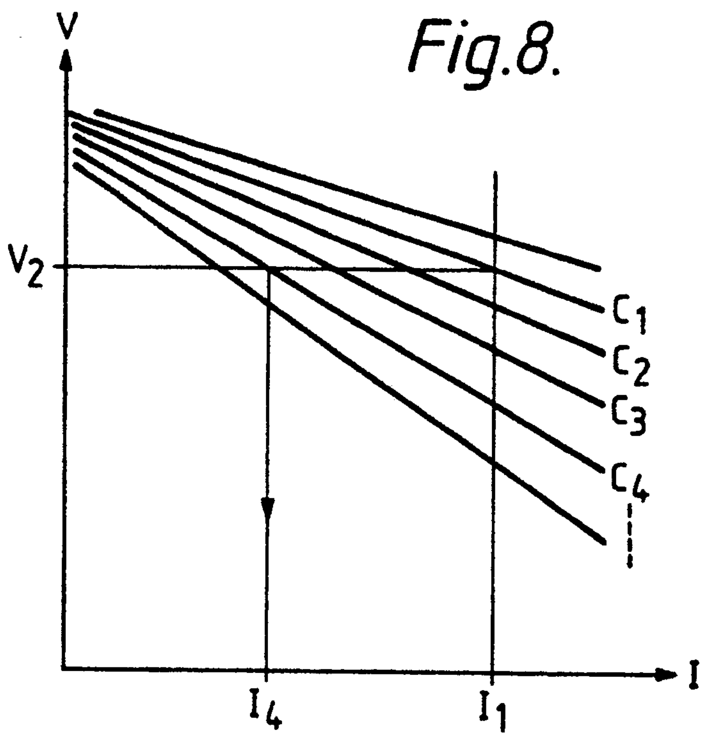

Fig.9.

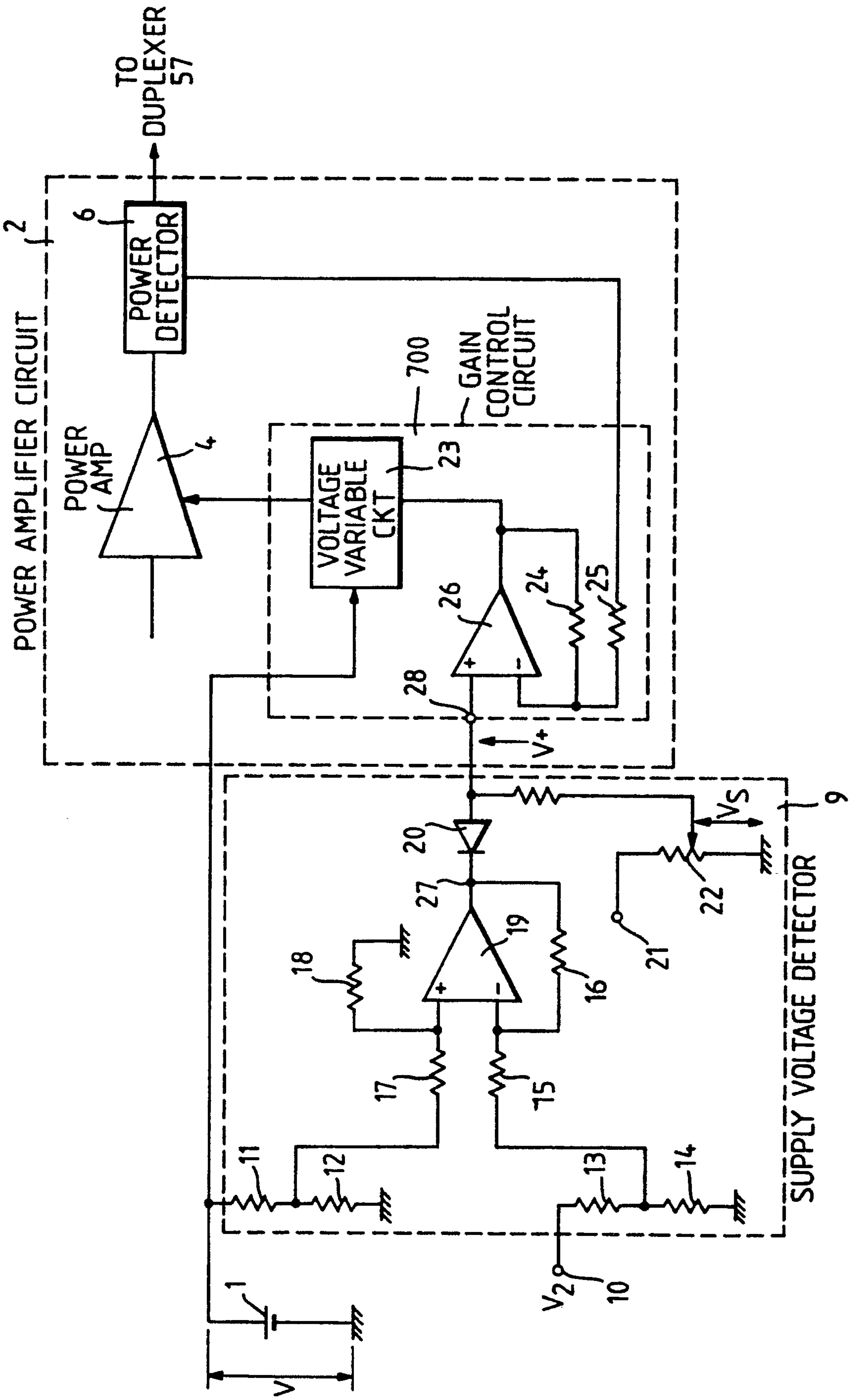
TO DUPLEXER 57
2
6
POWER DETECTOR
POWER AMPLIFIER CIRCUIT
POWER AMP
4
700
GAIN CONTROL CIRCUIT
VOLTAGE VARIABLE CKT
23
26
24
25
28
V+
20
27
19
18
16
17
15
11
12
13
14
21
22
$V_S$
9
SUPPLY VOLTAGE DETECTOR
1
V
$V_2$
10

Fig.10.

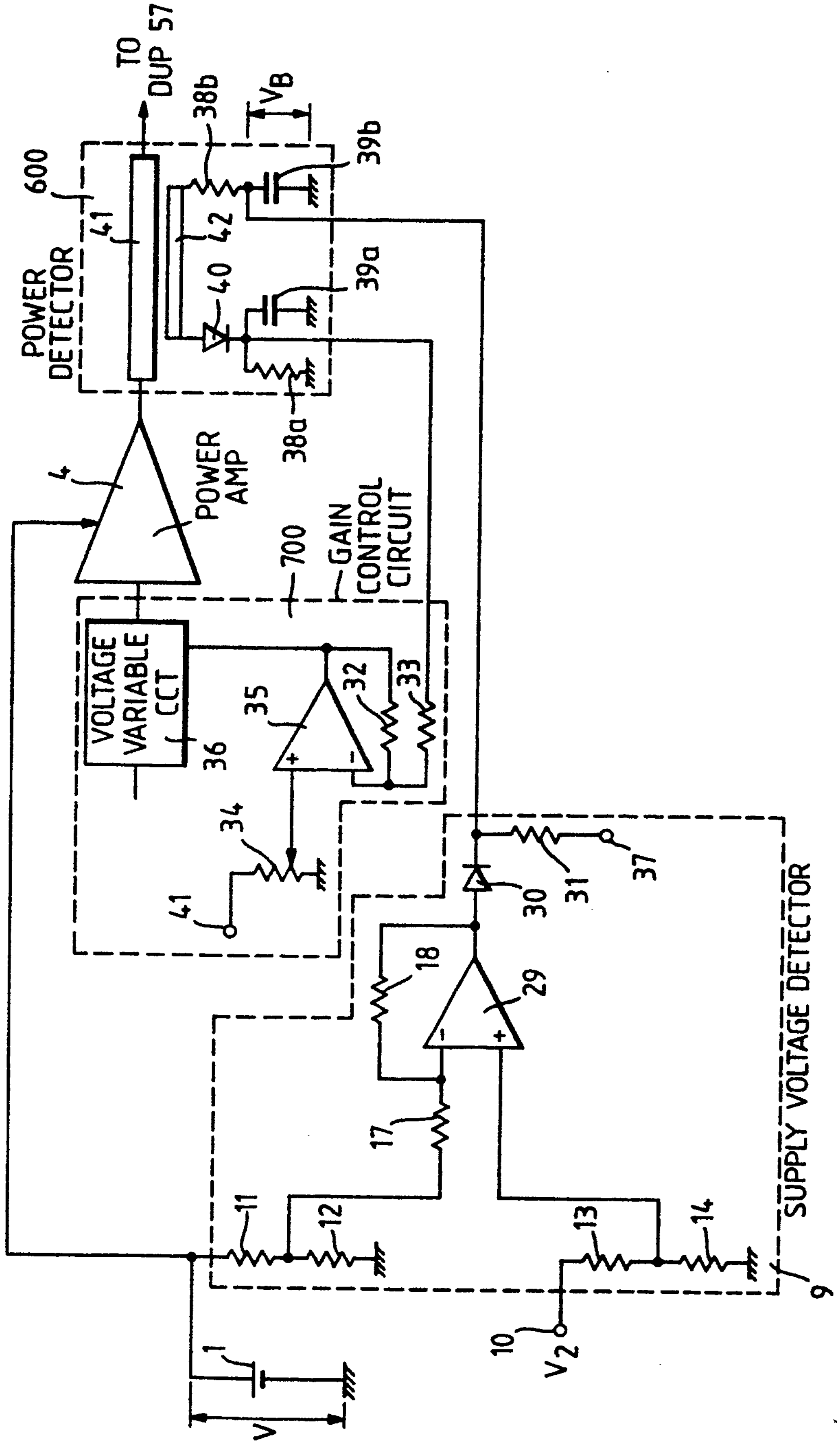
TO DUP 57
38b
$V_B$
600
39b
POWER DETECTOR
41
42
40
39a
38a
4
POWER AMP
700
GAIN CONTROL CIRCUIT
VOLTAGE VARIABLE CCT
36
35
32
33
34
41
30
31
37
18
29
17
11
12
13
14
SUPPLY VOLTAGE DETECTOR
9
10
$V_2$
1
V